# EUROPÄISCHE PATENTSCHRIFT

(11) **EP 3 010 320 B1**
(45) Veröffentlichungstag und Bekanntmachung des Hinweises auf die Patenterteilung: **29.04.2020**
(21) Anmeldenummer: 14464013.3
(22) Anmeldetag: 13.10.2014
(51) Int. Cl.: H05K 7/20

(54) **Vorrichtung zur Kühlung einer elektronischen Steuereinheit und Steuergerät für ein Kraftfahrzeug**
Device for cooling an electronic control unit and control device for a motor vehicle
Dispositif de refroidissement d'une unité de commande électronique et appareil de commande pour un véhicule automobile

(43) Veröffentlichungstag der Anmeldung: 20.04.2016
(73) Patentinhaber: Continental Automotive GmbH, 30165 Hannover (DE)
(72) Erfinder: Peck, Stefan, 89407 Dillingen a. d. Donau (DE); Tarnovetchi, Marius, 300516 Timisoara (RO)

(56) Entgegenhaltungen:
- WO-A1-2008/040578
- GB-A- 2 343 164
- US-A1- 2007 037 506
- US-A1- 2014 216 696

## Beschreibung

Die Erfindung betrifft ein Steuergerät für ein Kraftfahrzeug mit einer Vorrichtung zur Kühlung einer elektronischen Steuereinheit.

Elektrische Geräte, wie Steuergeräte für Kraftfahrzeuge, können erhöhten Temperaturen ausgesetzt sein. Da die elektrischen Komponenten in den Geräten im Betrieb zusätzlich Verlustleistung erzeugen und somit sich erhitzen, können Temperaturen entstehen, die zur Zerstörung der elektrischen Komponenten führen.

Um zu verhindern, dass sich die elektrischen Komponenten, und das jeweilige elektrische Gerät insgesamt, zu stark erhitzen, werden die elektrischen Komponenten, beispielsweise über die Leiterplatte, thermisch an das zugehörige Gehäuse mittels einer Wärmeleitpaste angebunden. Das Gehäuse wiederum verfügt über Kühlrippen, bei denen thermische Energie an die Umgebungsluft abgeführt wird. Je höher die Luftstromgeschwindigkeit an den Kühlrippen ist, desto besser die Abführung der thermischen Energie und damit die Kühlwirkung. Eine hohe Luftstromgeschwindigkeit kann beispielsweise durch den Fahrtwind erzeugt werden. Dadurch können die Kühlrippen und damit die erwärmten elektrischen Komponenten besser gekühlt werden. Wenn kein zusätzlicher Luftstrom vorhanden ist, sorgt die natürliche Konvektion für die Abführung der thermischen Energie. Die thermische Energie kann auch durch Kühlrohre, welche an das Gehäuse angebracht sind, abgeführt werden. Die Kühlrohre werden von einer Flüssigkeit durchströmt, welche die thermische Energie der Rohre abführt. Kühlrohre werden bevorzugt eingesetzt wenn die Umgebungsbedingungen es nicht zulassen die Verlustleistung ausreichend abzuführen, beispielsweise wenn die Luftströmung nicht ausreichend ist oder die abzuführende thermische Energie sehr hoch ist.

Eine weitere Möglichkeit der Kühlung besteht in der Verwendung von elektrisch betriebenen Ventilatoren zur Erzeugung eines Luftstromes. Dies ist eine vergleichsweise kostenintensive Lösung, da allein die Anschaffung eines Ventilators mit Spannungsversorgung mit erhöhten Kosten verbunden ist. Die benötigte elektrische Energie, um den Ventilator in einem Kraftfahrzeug, beispielsweise für die Motorsteuerung, zu betreiben, erhöht auch den Kraftstoffverbrauch. Weiterhin beanspruchen herkömmliche Ventilatoren Raum, der für andere Komponenten des Kraftfahrzeugs genutzt werden könnte.

US 2007/0037506 A1 offenbarte einen rechenförmigen Ventilator mit einem piezoelektrischen Aktuator, welche mit einer rechenförmigen Klinge gekoppelt ist. Die Klinge hat eine Basis mit zwei oder mehr Zinken, die sich von der Basis weg erstrecken. Die Zinken können zwischen den Rippen eines Kühlkörpers angeordnet sein.

US 2014/0216696 A1 offenbart eine Kühlvorrichtung, bei der eine Mehrzahl von Rippen eines Kühlkörpers zwischen einem ebenen Körper und einem Auslass der Kühlvorrichtung angeordnet sind. In Reaktion auf das Anlegen eines elektrischen Wechselstroms an ein piezoelektrischen Element schwingt ein bewegliches Ende des ebenen Körpers um einen Luftstrom zum Auslass zu erzeugen.

WO 2008/040578 A1 betrifft ein Schaltnetzteil, das wenigstens einen Piezolüfter umfasst, welcher einen Luftstrom an einem Transformator und/oder an einem Schaltelement und/oder an einer Diode bewirkt. Der erzeugte Luftstrom ist gezielt auf die zu kühlenden Komponenten lenkbar, wobei der Luftdurchsatz insgesamt gering bleibt und damit auch keine Verschmutzung durch Luftpartikel entsteht.

Es ist daher eine Aufgabe der vorliegenden Offenbarung, eine besonders einfache und/oder kostengünstige und/oder wartungsarme Vorrichtung eines Steuergeräts für ein Kraftfahrzeug anzugeben mit der Bauteile gekühlt werden können.

Diese Aufgabe wird durch ein Steuergerät gemäß Anspruch 1 gelöst. Vorteilhafte Weiterbildungen sind in den abhängigen Ansprüchen angegeben.

Es wird eine elektronische Steuereinheit mit einer Vorrichtung zur Kühlung der elektronischen Steuereinheit angegeben. Die Steuereinheit ist ein Steuergerät für ein Kraftfahrzeug. Bei dem elektronischen Steuergerät (ECU = electronic control unit) handelt es sich insbesondere um ein Motorsteuergerät.

Die erfindungsgemäße Vorrichtung zur Kühlung der elektronischen Steuereinheit weist wenigstens ein erstes Bauteil mit wenigstens einem ersten Abschnitt und wenigstens einem zweiten Abschnitt auf. Der wenigstens eine zweite Abschnitt ist an der Steuereinheit montierbar. Insbesondere ist er derart an der Steuereinheit montierbar, dass er ortsfest zu der Steuereinheit ist. Der wenigstens eine erste Abschnitt ist durch mechanische Anregung - insbesondere mittels mechanischer Vibrationen der Steuereinheit - in Schwingungen relativ zur Steuereinheit versetzbar, um einen Luftstrom zur Luftkühlung der Steuereinheit zu erzeugen.

In einem Kraftfahrzeug, oder auch anderen Transportmitteln, entstehen im Betrieb Vibrationen bzw. Schwingungen, die auf die einzelnen Komponenten und Bauteile übertragen werden. Diese durch den Betrieb bereits vorhandenen Vibrationen, und die damit frei zur Verfügung stehende kinetische Energie, werden durch die Erfindung ausgenützt, um das Bauteil zum Schwingen zu bringen. Das erste Bauteil ist derart beschaffen und dimensioniert, dass mechanische Vibrationen des Steuergeräts im Betrieb des Kraftfahrzeugs den ersten Abschnitt zu den mechanischen Schwingungen anregen, mittels welcher das Bauteil den Luftstrom zur Konvektionskühlung des Steuergeräts erzeugt.

Durch die Schwingungen des ersten Abschnitts des wenigstens einen ersten Bauteils wird ein Luftstrom bzw. werden Turbulenzen über der zu kühlenden Stelle erzeugt. Die Geschwindigkeit der bewegten Luft ist größer als die natürliche Konvektion. Dadurch erfolgt eine gezielte und verbesserte Kühlung der elektrischen Komponenten, welche in der näheren räumlichen Umgebung des wenigstens einen ersten Bauteils angeordnet sind. Für die Schwingungserzeugung muss mit Vorteil keine zusätzliche Energie bereitgestellt werden. Die durch den Betrieb des Kraftfahrzeugs ohnehin erzeugte Schwingungsenergie wird in Bewegungsenergie des Bauteils übertragen, welches die Luft in Bewegung versetzt, das Bauteil umgibt. Die bewegte Luft transportiert Wärme vom wenigstens einen ersten Bauteil ab. Durch diese Konvektion wird das wenigstens eine erste Bauteil gekühlt, was zu einer Kühlung von angrenzenden oder benachbarten elektrischen Komponenten führt, zum Beispiel mittels Wärmeleitung zu dem ersten Bauteil hin. Die Luft kann durch die Bewegung selbst auch eine Abkühlung erfahren.

Gemäß einer weiteren vorteilhaften Ausgestaltung der Erfindung umfasst die Vorrichtung wenigstens ein Befestigungsmittel, an dem der zweite Abschnitt des wenigstens einen ersten Bauteils befestigt ist, wobei das Befestigungsmittel an der Steuereinheit montiert ist. Dadurch wird ein stabiler Befestigungsbereich erreicht, mittels welchem insbesondere eine Drehachse oder Biegeachse für die Schwingung des ersten Abschnitts festgelegt ist.

Gemäß einer vorteilhaften Ausgestaltung der Erfindung weist die Vorrichtung wenigstens ein zweites Bauteil mit wenigstens einem ersten Abschnitt und wenigstens einem zweiten Abschnitt auf, wobei der wenigstens eine erste Abschnitt durch mechanische Anregung - insbesondere durch Anregung mittels mechanischer Vibrationen der Steuereinheit - in mechanische Schwingungen relativ zur Steuereinheit versetzbar ist um einen weiteren Luftstrom zur Luftkühlung der Steuereinheit zu erzeugen. Durch ein zusätzliches zweites Bauteil wird die Kühlwirkung verstärkt.

Das erste und ggf. das zweite Bauteil sind dabei mit den jeweiligen zweiten Abschnitten an der Steuereinheit derart montiert, dass die zweiten Abschnitte ortsfest zu der Steuereinheit fixiert sind.

In einer weiteren bevorzugten Ausgestaltung der Erfindung sind das wenigstens eine erste Bauteil und das wenigstens eine zweite Bauteil durch eine mechanische Kopplung miteinander verbunden. Insbesondere sind sie derart durch die mechanische Kopplung miteinander verbunden, dass die mechanischen Schwingungen der ersten Abschnitte der jeweiligen Bauteile einander gegenseitig beeinflussen. Durch Vibrationen, welche auf das erste und zweite Bauteil wirken, erfolgen Schwingungen des ersten und zweiten Bauteils. Durch die Kopplung wird erreicht, dass die Schwingungen des wenigstens einen ersten Bauteils auch auf das zweite Bauteil wirken kann, und umgekehrt, so dass eine Verstärkung der Schwingungen erreicht werden kann. Diese Schwingungen erreichen ihr Maximum, wenn sie durch die Resonanzfrequenz des gekoppelten Systems angeregt werden. Weiterhin kann dadurch nicht nur ein Luftstrom auf einer Seite des wenigstens einen ersten Bauteils erzeugt werden, sondern auch auf der gegenüberliegenden Seite. Dadurch erfolgt eine Selbstkühlung der Vorrichtung sich.

Beispielsweise nimmt die Schwingungsamplitude der ersten Abschnitte mit dem Abstand von dem jeweiligen zweiten Abschnitt zu. Bei einer Ausgestaltung ist das zweite Bauteil an der dem zweiten Abschnitt des zweiten Bauteils zugewandten Seite seines ersten Abschnitts mit der von dem zweiten Abschnitt des ersten Bauteils abgewandten Seite des ersten Abschnitts des ersten Bauteils gekoppelt. Auf diese Weise kann die Vorrichtung dazu ausgebildet sein, dass der erste Abschnitt des ersten Bauteils einen Luftstrom an der dem zweiten Abschnitt des zweiten Bauteils benachbarten Seite des ersten Abschnitts des zweiten Bauteils erzeugt und/oder dass der erste Abschnitt des zweiten Bauteils einen Luftstrom an der dem zweiten Abschnitt des ersten Bauteils benachbarten Seite des ersten Abschnitts des ersten Bauteils erzeugt.

In einer weiteren bevorzugten Ausgestaltung der Erfindung ist die mechanische Kopplung als Lager oder Scharnier ausgebildet. Das Lager oder Scharnier ist insbesondere zwischen dem ersten Abschnitt des ersten Bauteils und dem zweiten Bauteil ausgebildet. Ein Scharnier ermöglicht Bewegungen um einer Achse. Ein Lager kann so ausgebildet sein, dass damit Bewegungen in zwei- oder drei Raumrichtungen möglich sind. Dies stellt sicher, dass das erste und zweite Bauteil in der gekoppelten Anordnung mit möglichst wenig Bewegungsverlust schwingen können.

In einer weiteren vorteilhaften Ausgestaltung der Erfindung ist der zweite Abschnitt des zweiten Bauteils an der Steuereinheit montiert, so dass der zweite Abschnitt ortsfest zur Steuereinheit ist. Dadurch wird erreicht, dass das zweite Bauteil um seinen fest montierten zweiten Abschnitt schwingt, und eine zusätzliche Kühlung im Bereich der Steuereinheit erfolgt.

In einer weiteren vorteilhaften Ausgestaltung der Erfindung sind das wenigstens eine erste und das wenigstens eine zweite Bauteil hintereinander oder nebeneinander angeordnet. "Hintereinander angeordnet" bedeutet dabei insbesondere, dass die Haupterstreckungsebenen der ersten Abschnitte zueinander parallel und voneinander beabstandet sind, wenn die Bauteile in Ruhe sind. "Nebeneinander angeordnet" bedeutet dabei insbesondere, dass die ersten Abschnitte der Bauteile sich eine gemeinsame Haupterstreckungsebene teilen. Wenn das wenigstens eine erste und das zweite Bauteil hintereinander angeordnet sind wird ein verstärkter Luftstrom in den beiden Richtungen der Schwingungen der Bauteile erreicht. Wenn das wenigstens eine erste und das zweite Bauteil nebeneinander angeordnet sind, wird ein Luftstrom über die gesamte Breite der Bauteile erreicht. Der gesamte Luftstrom kann auch in diesem Fall verstärkt sein.

Es hat sich bewährt, dass das wenigstens eine erste und das zweite Bauteil hinsichtlich Größe, Form und/oder Materialzusammensetzung unterschiedlich ausgebildet sind. Dadurch wird erreicht, dass das wenigstens eine erste und zweite Bauteil auf eine bestimmte Resonanzfrequenz eingestellt werden können, bei der sich eine maximale Schwingungsauslenkung einstellt. Weiterhin kann durch die unterschiedlichen Resonanzfrequenzen oder auch Eigenfrequenzen die Vorrichtung in einem größeren Frequenzbereich betrieben werden.

Zweckmäßigerweiser weisen das wenigstens eine erste und/oder das wenigstens eine zweite Bauteil Blech auf oder bestehen aus Blech. Blech ist besonders geeignet für Biegevorgänge und Schwingungen, da es flach ausgebildet ist und bei geringen Auslenkungen elastisch verformbar ist.

Im Folgenden soll die Erfindung anhand der in den Figuren 1 bis 3 dargestellten Ausführungsbeispiele beispielhaft erläutert werden. Es zeigen schematisch:
- Figur 1: Steuereinheit mit beispielhaften Vorrichtungen;
- Figur 2: Vorrichtung mit Bauteilen in Reihe;
- Figur 3: Vorrichtung mit Mehrfachbauteilen;
- Figur 4a: Vorrichtung mit gekoppelten Bauteilen in Vorderansicht;
- Figur 4b: Vorrichtung der Figur 4a in Seitenansicht; und
- Figur 5: Vorrichtung zur Kühlung in einer elektronischen Komponente integriert.

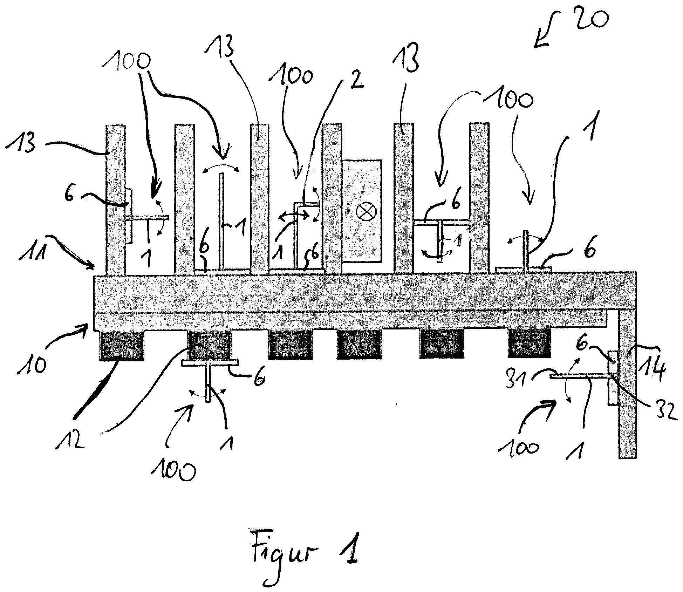

Figur 1 zeigt eine Steuereinheit 20, welche eine Leiterplatte 10, auch als printed circuit board (PCB) bekannt, aufweist, welche mit elektronischen Komponenten 12 bestückt ist. Die Steuereinheit 20 weist ferner ein Gehäuse mit einem Gehäusedeckel 11 sowie einer Gehäuseseitenplatte 14 auf.

An dem Gehäusedeckel 11 sind Kühlrippen 13 angeordnet oder ausgebildet. Erfindungsgemäße Vorrichtungen 100 zur Kühlung der Steuereinheit 20 sind beispielhaft an der von der Leiterplatte 10 abgewandten Außenseite des Gehäuses zwischen den Kühlrippen 13 und auf dem Grundkörper des Gehäusedeckels 11 montiert. Weitere erfindungsgemäße Vorrichtungen 100 sind im Inneren des Gehäuses auf der Gehäuseseitenplatte 14 und auf einer der elektronischen Komponenten 12 montiert.

Die Vorrichtungen 100 weisen in den dargestellten Ausführungsbeispielen jeweils wenigstens ein erstes Bauteil 1 mit wenigstens einem ersten Abschnitt 31 und wenigstens einem zweiten Abschnitt 32 auf (siehe exemplarisch die Vorrichtung 100 rechts unten in Figur 1), wobei der wenigstens eine erste Abschnitt 31 durch mechanische Anregung in Schwingung relativ zur Steuereinheit 20 versetzbar ist, so dass er einen Luftstrom oder Turbulenzen zur Luftkühlung der Steuereinheit 20 erzeugt, und der wenigstens eine zweite Abschnitt 32 an der Steuereinheit 20 montiert ist. Die mechanische Anregung wird zweckmäßigerweise durch mechanische Vibrationen der Steuereinheit 20 hervorgerufen, die im Betrieb der Steuereinheit auftreten, zum Beispiel während der Fahrt eines Kraftfahrzeugs in dem die Steuereinheit eingebaut ist.

Die Vorrichtung 100 kann wenigstens ein Befestigungsmittel 6 aufweisen, an dem der zweite Abschnitt 32 des wenigstens einen ersten Bauteils 1 befestigt ist, wobei das Befestigungsmittel 6 an der Steuereinheit 20 montiert ist. Das Befestigungsmittel 6 kann einteilig mit dem Bauteil 1 ausgebildet sein, insbesondere mit dessen zweitem Abschnitt 32. Das Befestigungsmittel 6 kann Klemmen aufweisen. Dadurch werden keine zusätzlichen Fixierungsmittel wie Schrauben, Kleber etc. benötigt. Das Befestigungsmittel 6 kann auch ein Scharnier oder eine Lagerung aufweisen, so dass die Schwingung des wenigstens einen ersten Bauteils 1 mit geringem Widerstand erfolgt. Ein Scharnier ermöglicht Bewegungen um eine Achse. Ein Lager kann so ausgebildet sein, dass damit Bewegungen in zwei- oder drei Raumrichtungen möglich sind.

Die Vorrichtung 100 kann weiterhin ein zweites Bauteil 2 mit wenigstens einem ersten Abschnitt 31 und wenigstens einem zweiten Abschnitt 32 aufweisen, wobei der wenigstens eine erste Abschnitt 31 durch mechanische Anregung in Schwingung relativ zur Steuereinheit 20 versetzbar ist um einen weiteren Luftstrom zu erzeugen, und dadurch eine Luftkühlung zu hervorzurufen. Das erste und zweite Bauteil 1, 2 können durch eine mechanische Kopplung - zum Beispiel ein Scharnier oder ein Lager - miteinander verbunden sein, wobei das Schwingen der ersten Abschnitte 31 des ersten und zweiten Bauteils 1, 2 weiterhin möglich ist.

Die Vorrichtung 100 kann so ausgelegt werden, dass sie in verschiedenen Frequenzbereichen der Schwingungen einen Luftstrom erzeugt. Dies kann beispielsweise durch die Größe, Form und/oder die Materialzusammensetzung des wenigstens einen ersten und/oder des wenigstens einen zweiten Bauteils 1, 2 erreicht werden. Die Vorrichtung 100 kann so ausgelegt werden, dass sie in einem vorgegebenen Frequenzbereich einen besonders starken Luftstrom erzeugt.

Vorteilhaft ist auch wenn das wenigstens eine erste Bauteil 1 oder das zweite Bauteil 2 Blech aufweist, das aufgrund seiner flachen Ausführung gute Schwingungseigenschaften aufweist. Beispielsweise ist zumindest der erste Abschnitt 31 jeweils aus Blech hergestellt. Das wenigstens eine erste und/oder das zweite Bauteil 1, 2 - insbesondere der jeweilige erste Abschnitt 31 - kann auch als Stab/Stäbchen, Plättchen oder einer anderen Form ausgebildet sein, welche zu mechanischen Schwingungen erregbar ist, die zur Erzeugung eines Luftstroms zur Konvektionskühlung geeignet ist. Als Material kann jedes elastische Material verwendet werden.

Das Material für das erste und/oder zweite Bauteil 1, 2 kann ein thermisch leitfähiges Material enthalten, wie beispielsweise ein Metall oder einen thermisch leitfähigen Kunststoff. Das wenigstens eine erste und/oder zweite Bauteil 1, 2 kann entsprechend unmittelbar an einer erwärmten Oberfläche - zum Beispiel des Gehäusedeckels 11, der Gehäuseseitenplatte 14 oder einer der Kühlrippen 13 - bzw. in der Nähe, direkt auf oder stellenweise innerhalb einer erwärmten elektrischen Komponente 12 angebracht werden. Dadurch kann das wenigstens eine erste und/oder das zweite Bauteil 1, 2 selbst thermische Energie aufnehmen - insbesondere mittels Wärmeleitung - und durch die Schwingungen seines ersten Abschnitts 31 die thermische Energie und die Umgebungsluft abgeben, insbesondere mittels Konvektion. Durch die Schwingungen des ersten Abschnitts 31 wird ein relativer Luftstrom zum Bauteil 1, 2 selbst erzeugt. Der relative Luftstrom um das Bauteil 1, 2 kühlt das Bauteil 1, 2.

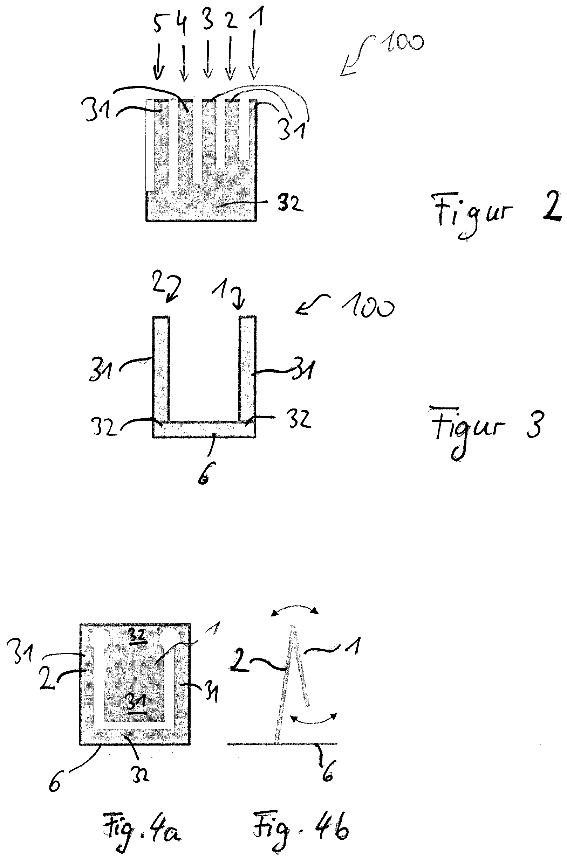

Figur 2 zeigt ein Ausführungsbeispiel einer erfindungsgemäßen Vorrichtung 100, bei der ein erstes und ein zweites Bauteil 1, 2 sowie weitere Bauteile 3, 4, 5 nebeneinander angeordnet sind, entsprechend einer Lamellenform, auch Kammform genannt. Die ersten Abschnitte 31 der Bauteile 1 bis 5 haben die gleiche Haupterstreckungsebene, entsprechend der Zeichnungsebene der Figur 2. Die ersten Abschnitte 31 sind als Blättchen ausgeführt und weisen unterschiedliche Längen auf. Durch die unterschiedliche Länge schwingen die ersten Abschnitte 31 der Bauteile 1, 2, 3, 4, 5 mit unterschiedlichen Frequenzen. Dadurch erfolgt eine Schwingung ersten Abschnitte 31 der Bauteile 1, 2, 3, 4, 5 über einen vergrößerten Frequenzbereich, bzw. kann bei unterschiedlichen Resonanzfrequenzen schwingen und kühlen. Die ersten Abschnitte 31 münden in einen gemeinsamen zweiten Abschnitt 32 der Bauteile 1 bis 5, der mit den ersten Abschnitten 31 vorliegend einstückig ausgebildet ist.

Figur 3 zeigt ein weiteres Ausführungsbeispiel, wobei das wenigstens eine erste und zweite Bauteil 1, 2, hintereinander, also mit parallelen Haupterstreckungsebenen (senkrecht zur Zeichnungsebene) der jeweiligen ersten Abschnitte 31, in einem Abstand voneinander auf einem Befestigungsmittel 6 montiert sind. Durch die Parallelschaltung des wenigstens einen ersten und zweiten Bauteils 1, 2 wird der Luftstrom verstärkt. Das erste und zweite Bauteil 1, 2 mit dem Befestigungsmittel 6 können auch einteilig ausgeführt sein.

Figur 4a zeigt eine Vorderansicht einer Vorrichtung 100 gemäß einem exemplarischen Ausführungsbeispiel mit einem ersten und einem zweiten Bauteil 1, 2 welche mechanisch gekoppelt sind. Das zweite Bauteil 2 ist mit seinem festen Ende - d.h. dem zweiten Abschnitt 32 - auf dem Befestigungsmittel 6 montiert. Der zweite Abschnitt 32 des ersten Bauteils 1 ist an dem vom zweiten Abschnitt 32 des zweiten Bauteils 2 abgewandten Ende des ersten Abschnitts 31 des zweiten Bauteils 31 fixiert.

Das erste und das zweite Bauteil 1, 2 kann damit einzeln oder auch gekoppelt schwingen. Beispielsweise kann so ein Doppelpendel aus dem ersten und dem zweiten Bauteil 1, 2 gebildet sein. Dieses gekoppelte System kann auch als "Double Swing Resonance Fan" bezeichnet werden.

Die vorliegende Ausgestaltung kann zu einer verstärkten Gesamtschwingung der gekoppelten Bauteile 1, 2 führen, insbesondere wenn die anregende mechanische Frequenz der Resonanzfrequenz des gekoppelten Systems entspricht. Dabei wird nicht nur ein Luftstrom auf einer vom zweiten Abschnitt 32 abgewandten Seite des jeweiligen Blättchens 31 erzeugt, sondern auch auf der gegenüberliegenden, dem zweiten Abschnitt 32 des jeweils anderen Bauteils 1, 2 zugewandten Seite. Dadurch kann die Vorrichtung sich selbst kühlen, und/or heiße Stellen direkt am Gehäusedeckel 11 bzw. an der Gehäuseseitenplatte 14 und/oder an den Kühlrippen 13 kühlen und einen Luftstrom zwischen den die Vorrichtung 100 umgebenden Kühlrippen erzeugen.

Dieses Prinzip kann so erweitert werden, dass in alle Raumrichtungen ein Luftstrom erzeugt werden kann. Ein weiterer Vorteil besteht darin, dass das Gehäuse oder die elektronischen Komponenten 12 lokal auf ein eingegrenztes Gebiet gekühlt werden können. Dadurch Bauraum eingespart und ggf. für anderweitige Nutzung zur Verfügung gestellt werden. Bei herkömmlichen Luftkühlungsmethoden werden auch Teile gekühlt die nicht gekühlt werden müssen, wodurch unnötig Energie verbraucht wird.

Das erste und zweite Bauteil 1, 2 können aus einem Stanzblech einstückig gebildet sein. Durch die Ausstanzung kann die Amplitude (der Schwingweg) der Schwingung optimiert, d.h. erhöht werden. Dies hat eine Verstärkung der Kühlwirkung zur Folge.

Figur 4b zeigt die Seitenansicht des ersten und des zweiten Bauteils 1, 2 aus Figur 4a.

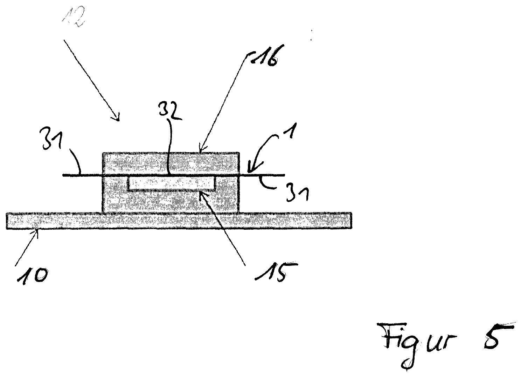

Figur 5 zeigt eine Kühl-Vorrichtung 100 mit einemersten Bauteil 1, das in eine elektronische Komponente 12 integriert ist.

Die elektronische Komponente 12 weist eine Integrierte Schaltung (IC) 15 auf, die in einem Komponentengehäuse 16 verkapselt ist. Sie ist auf der Leiterplatte 10, insbesondere im Inneren des Gehäusedeckels 11 der Steuereinheit 20 montiert. Zweckmäßigerweise können Anschlussbeinchen von der Integrierten Schaltung 15 durch das Komponentengehäuse 16 und aus diesem heraus geführt sein, um die elektronische Komponente 12 mit der Leiterplatte 12 zu verdrahten.

Der zweite Abschnitt 32 des ersten Bauteils 1 ist in dem Komponentengehäuse 16 angeordnet. Zwei erste Abschnitte 31 des ersten Bauteils 1 ragen an gegenüberliegenden Seiten aus dem Komponentengehäuse 167 heraus. Das erste Bauteil 1 ist beispielsweise zwischen der integrierten Schaltung (IC) der elektronischen Komponente 12 und deren komponentengehäuse 16 mittig befestigt. Die Breite des ersten Bauteils 1 überragt die Breite der elektronischen Komponente 12, so dass die zwei ersten Abschnitte 31 als Endbereiche des ersten Bauteils 1 über die elektronische Komponente 12 herausragen und entsprechend schwingbar gelagert sind. Im Falle einer Vibration oder Schwingung der Leiterplatte 10 der elektronischen Komponente 12 oder des Komponentengehäuses 16 wird diese Schwingung auf das erste Bauteil 1 übertragen, und die ersten Abschnitte 31 des ersten Bauteils 1 werden in mechanische Schwingung versetzt. Dadurch wird eine Luftverwirbelung oder auch ein Luftstrom erzeugt, welcher die warme Luft von der elektronischen Komponente 12 abführt. Das erste Bauteil 1 sorgt damit für eine Kühlung in seiner Umgebung, der elektronischen Komponente 12 und auch für seine eigene Kühlung.

Vorzugsweise ist das erste Bauteil 1 aus Blech gebildet und zur Wärmeabfuhr von der Integrierten Schaltung 15 und aus dem Komponentengehäuse 16 mittels Wärmeleitung ausgebildet. Die Wärme wird von dem zweiten Abschnitt 32 zu den ersten Abschnitten 31 geleitet und von dort beispielsweise mittels Konvektion dissipiert.

Es ist auch denkbar (nicht dargestellt), dass zwei zweite - Abschnitte 32 des ersten Bauteils 1 eingespannt sind, beispielsweise wie im vorigen Beispiel jeweils zwischen einer integrierten Schaltung (IC) 15 einer elektronischen Komponente 12 und deren Komponentengehäuse 16, und der erste Abschnitt 31 des ersten Bauteils 1 mittig zwischen den zwei zweiten Abschnitten 32 frei schwingbar angeordnet ist.

Alle vorstehend offenbarten Merkmale der Erfindung können sowohl einzeln als auch in Kombination miteinander für die erfindungsgemäße-Vorrichtung von Bedeutung sein.

Die erfindungsgemäße Vorrichtung kann bevorzugt für die Kühlung von Steuergeräten, insbesondere Motorsteuergeräten verwendet werden.

## Patentansprüche

1. Steuergerät für ein Kraftfahrzeug mit
- einer elektronischen Steuereinheit (20), die eine mit elektronischen Komponenten (12) bestückte Leiterplatte (10) und einen Gehäusedeckel (11) aufweist, und
- einer Vorrichtung (100) zur Kühlung der elektronischen Steuereinheit (20), mit einem ersten Bauteil (1), das einen ersten Abschnitt (31) und einen zweiten Abschnitt (32) aufweist, wobei der zweite Abschnitt (32) als ein festes Ende des Bauteils (1) derart an der Steuereinheit (20) montiert ist, dass er ortsfest zur Steuereinheit (20) fixiert ist, und der erste Abschnitt (31) ein frei schwingendes Ende des ersten Bauteils (1) enthält, wobei das erste Bauteil (1) derart beschaffen und dimensioniert ist, dass der erste Abschnitt (31) durch Anregung mittels mechanischer Vibrationen des Steuergeräts, die im Betrieb des Kraftfahrzeugs auf das Steuergerät übertragen werden, zu mechanischen Schwingungen relativ zur Steuereinheit (20) angeregt wird, mittels welcher das erste Bauteil (1) einen Luftstrom zur Konvektionskühlung der Steuereinheit (20) erzeugt.

2. Steuergerät nach Anspruch 1, mit einem zweiten Bauteil (2) das einen ersten Abschnitt (31) und einen zweiten Abschnitt (32) aufweist, wobei
- der erste Abschnitt (31) des zweiten Bauteils (2) ein frei schwingendes Ende des zweiten Bauteils (zwei) enthält und
- das zweite Bauteil (2) derart beschaffen und dimensioniert ist, dass sein erster Abschnitt (31) durch Anregung mittels mechanischer Vibrationen des Steuergeräts, die im Betrieb des Kraftfahrzeugs auf das Steuergerät übertragen werden, zu in mechanischen Schwingungen relativ zur Steuereinheit (20) angeregt wird, mittels welcher das zweite Bauteil (2) einen weiteren Luftstrom zur Konvektionskühlung der Steuereinheit (20) erzeugt.

3. Steuergerät nach Anspruch 2, wobei die ersten Abschnitte (31) des ersten und des zweiten Bauteils (1, 2) unterschiedliche Resonanzfrequenzen bezüglich der Vibrationen der Steuereinheit haben.

4. Steuergerät nach Anspruch 2 oder 3, wobei das wenigstens eine erste Bauteil (1) und das wenigstens eine zweite Bauteil (2) durch eine mechanische Kopplung miteinander verbunden sind, die als Scharnier, dass eine Bewegung um eine Achse ermöglicht, oder als Lager, dass eine Bewegung in zwei oder drei Richtungen ermöglicht, ausgebildet ist.

5. Steuergerät nach Anspruch 4, wobei die mechanische Kopplung als Lager oder Scharnier zwischen dem ersten Abschnitt (31) des ersten Bauteils (1) und dem zweiten Abschnitts (32) des zweiten Bauteils (2) derart ausgebildet ist, dass der erste Abschnitt (31) des zweiten Bauteils (2) den weiteren Luftstrom an der dem zweiten Abschnitt (32) des ersten Bauteils (1) benachbarten Seite des ersten Abschnitts (31) des ersten Bauteils (1) erzeugt.

6. Steuergerät nach Anspruch 5, wobei ein Doppelpendel aus den ersten Bauteil (1) und dem zweiten Bauteil (2) gebildet ist.

7. Steuergerät nach Anspruch 3, wobei das erste Bauteil (1), das zweite Bauteil (2) sowie weitere Bauteile (3, 4,5) kammförmig angeordnet sind und die ersten Abschnitte (31) der Bauteile (1, 2, 3, 4, 5) als Plättchen unterschiedlicher Länge ausgeführt sind.

8. Steuergerät nach Anspruch 1, wobei der zweite Abschnitt (32) des ersten Bauteils (1) in einem Komponentengehäuse (16) der elektronischen Komponente (12) angeordnet ist, und wobei der erste Abschnitt (31) und ein weiterer erster Abschnitt (31), der ein weiteres frei schwingendes Ende des ersten Bauteils (31) aufweist, an gegenüberliegenden Seiten aus dem Komponentengehäuse (16) herausragen.

9. Steuergerät nach einem der Ansprüche 1 bis 8, wobei das erste und/oder das zweite Bauteil (1, 2) Blech aufweist.

10. Steuergerät für ein Kraftfahrzeug gemäß einem der Ansprüche 1 bis 9, wobei an dem Gehäusedeckel (11) Kühlrippen (13) angeordnet oder ausgebildet sind und die Vorrichtung (100) zwischen den Kühlrippen (13) oder auf dem Grundkörper des Gehäusedeckels (11) oder auf der elektronischen Komponente (12) montiert ist.

## Claims

1. Control device for a motor vehicle having
- an electronic control unit (20) which has a circuit board (10) which is equipped with electronic components (12), and a housing cover (11), and
- an apparatus (100) for cooling the electronic control unit (20), with a first component (1) which has a first section (31) and a second section (32), wherein the second section (32) is mounted, as a fixed end of the component (1), on the control unit (20) in such a way that it is secured in a positionally fixed fashion to the control unit (20), and the first section (31) contains a freely oscillating end of the first component (1), wherein the first component (1) is constructed and dimensioned in such a way that, by excitation by means of mechanical vibrations of the control device which are transmitted to the control device while the motor vehicle is operating, the first section (31) is excited to oscillate mechanically relative to the control unit (20), by means of which oscillations the first component (1) generates an airstream to cool the control unit (20) by convection.

2. Control device according to Claim 1, having a second component (2) which has a first section (31) and a second section (32), wherein
- the first section (31) of the second component (2) contains a freely oscillating end of the second component (2), and
- the second component (2) is constructed and dimensioned in such that a way that, by excitation by means of mechanical vibrations of the control device which are transmitted to the control device while the motor vehicle is operating, the first section (31) of said second component (2) is excited to oscillate mechanically relative to the control unit (20) by means of which oscillations the second component (2) generates a further airstream to cool the control unit (20), by convection.

3. Control device according to Claim 2, wherein the first sections (31) of the first and second components (1, 2) have different resonant frequencies to the vibrations of the control unit.

4. Control device according to Claim 2 or 3, wherein the at least one first component (1) and the at least one second component (2) are connected to one another by means of a mechanical coupling which is embodied as a hinge which permits movement about an axis, or as a bearing which permits movement in two or three directions.

5. Control device according to Claim 4, wherein the mechanical coupling is embodied as a bearing or hinge between the first section (31) of the first component (1) and the second section (32) of the second component (2) in such a way that the first section (31) of the second component (2) generates the further airstream on that side of the first section (31) of the first component (1) which is adjacent to the second section (32) of the first component (1).

6. Control device according to Claim 5, wherein a double pendulum is formed from the first component (1) and the second component (2).

7. Control device according to Claim 3, wherein the first component (1), the second component (2) and further components (3, 4, 5) are embodied in the form of a comb, and the first sections (31) of the components (1, 2, 3, 4, 5) are embodied as small plates of different lengths.

8. Control device according to Claim 1, wherein the second section (32) of the first component (1) is arranged in a component housing (16) of the electronic component (12), and wherein the first section (31) and a further first section (31) which has a further freely oscillating end of the first component (31) project out of the component housing (16) on opposite sides.

9. Control device according to one of Claims 1 to 8, wherein the first and/or second components (1, 2) have/has sheet metal.

10. Control device for a motor vehicle according to one of Claims 1 to 9, wherein cooling fins (13) are arranged or formed on the housing cover (11), and the apparatus (100) is mounted between the cooling fins (13) or on the base body of the housing cover (11) or on the electronic component (12).

## Revendications

1. Contrôleur pour un véhicule automobile, comprenant
- une unité de commande électronique (20), qui possède un circuit imprimé (10) équipé de composants électroniques (12) et un couvercle de boîtier (11), et
- un dispositif (100) destiné à refroidir l'unité de commande électronique (20), comprenant un premier élément structural (1) qui possède une première portion (31) et une deuxième portion (32), la deuxième portion (32) étant montée sur l'unité de commande (20) en tant qu'extrémité fixe de l'élément structural (1) de telle sorte qu'elle est calée en position fixe par rapport à l'unité de commande (20), et la première portion (31) contenant une extrémité oscillant librement du premier élément structural (1), le premier élément structural (1) étant configuré et dimensionné de telle sorte que la première portion (31), par excitation au moyen de vibrations mécaniques du contrôleur qui sont transmises au contrôleur lors du fonctionnement du véhicule automobile, est excitée en oscillations mécaniques par rapport à l'unité de commande (20), au moyen desquelles le premier élément structural (1) génère un courant d'air destiné au refroidissement par convection de l'unité de commande (20).

2. Contrôleur selon la revendication 1, comprenant un deuxième élément structural (2) qui possède une première portion (31) et une deuxième portion (32),
- la première portion (31) du deuxième élément structural (2) contient une extrémité oscillant librement du deuxième élément structural (2) et
- le deuxième élément structural (2) est configuré et dimensionné de telle sorte que sa première portion (31), par excitation au moyen de vibrations mécaniques du contrôleur qui sont transmises au contrôleur lors du fonctionnement du véhicule automobile, est excitée en oscillations mécaniques par rapport à l'unité de commande (20), au moyen desquelles le deuxième élément structural (2) génère un courant d'air supplémentaire destiné au refroidissement par convection de l'unité de commande (20).

3. Contrôleur selon la revendication 2, les premières portions (31) du premier et du deuxième élément structural (1, 2) ayant des fréquences de résonance différentes pour ce qui concerne les vibrations de l'unité de commande.

4. Contrôleur selon la revendication 2 ou 3, le premier élément structural (1) et l'au moins un deuxième élément structural (2) étant reliés ensemble par le biais d'un accouplement mécanique qui est réalisé sous la forme d'une charnière qui rend possible un mouvement autour d'un axe, ou sous la forme d'un palier qui rend possible un mouvement dans deux ou trois directions.

5. Contrôleur selon la revendication 4, l'accouplement mécanique sous la forme d'un palier ou d'une charnière entre la première portion (31) du premier élément structural (1) et la deuxième portion (32) du deuxième élément structural (2) étant configuré de telle sorte que la première portion (31) du deuxième élément structural (2) génère le courant d'air supplémentaire au niveau du côté de la première portion (31) du premier élément structural (1) qui est voisin de la deuxième portion (32) du premier élément structural (1).

6. Contrôleur selon la revendication 5, un double pendule étant formé à partir du premier élément structural (1) et du deuxième élément structural (2).

7. Contrôleur selon la revendication 3, le premier élément structural (1), le deuxième élément structural (2) ainsi que des éléments structuraux supplémentaires (3, 4, 5) étant disposés en forme de peigne et les premières portions (31) des premiers éléments structuraux (1, 2, 3, 4, 5) étant réalisées sous la forme de plaquettes de différentes longueurs.

8. Contrôleur selon la revendication 1, la deuxième portion (32) du premier élément structural (1) étant disposée dans un boîtier à composants (16) des composants électroniques (12) et la première portion (31) et une première portion (31) supplémentaire, laquelle possède une extrémité oscillant librement du premier élément structural (31), faisant saillie hors du boîtier à composants (16) par des côtés opposés.

9. Contrôleur selon l'une des revendications 1 à 8, le premier et/ou le deuxième élément structural (1, 2) comportant de la tôle.

10. Contrôleur pour un véhicule automobile selon l'une des revendications 1 à 9, des ailettes de refroidissement (13) étant disposées ou configurées sur le couvercle de boîtier (11) et le dispositif (100) étant monté entre les ailettes de refroidissement (13) ou sur le corps de base du couvercle de boîtier (11) ou sur les composants électroniques (12).
